# FASCICULE DE BREVET EUROPEEN

(11) **EP 3 468 037 B1**
(45) Date de publication et mention de la délivrance du brevet: **30.12.2020**
(21) Numéro de dépôt: 18189852.9
(22) Date de dépôt: 21.08.2018
(51) Int. Cl.: H03H 9/21

(54) **RESONATEUR PIEZO-ELECTRIQUE DE PETITE TAILLE**
KLEINER PIEZOELEKTRISCHER RESONATOR
SMALL PIEZOELECTRIC RESONATOR

(30) Priorité: 03.10.2017 EP 17194584
(43) Date de publication de la demande: 10.04.2019
(73) Titulaire: Micro Crystal AG, 2540 Grenchen (CH)
(72) Inventeur: Dalla Piazza, Silvio, 2610 St-Imier (CH); Staub, Felix, 3425 Koppigen (CH)
(74) Mandataire: ICB SA

(56) Documents cités:
- US-A1- 2010 277 041
- US-A1- 2013 175 903
- US-B2- 7 626 318
- US-B2- 8 400 049

## Description

### DOMAINE TECHNIQUE

L'invention concerne un résonateur piézo-électrique de petite taille. Ce résonateur piézo-électrique peut être un résonateur à diapason à quartz pour être utilisé en liaison à au moins un circuit électronique dans le domaine de l'horlogerie, l'informatique, les télécommunications, voire la médecine.

### ARRIÈRE-PLAN TECHNOLOGIQUE

Dans un résonateur piézo-électrique à diapason traditionnel, un champ électrique d'excitation est créé dans une direction parallèle à l'une des faces par des électrodes dont certaines sont disposées sur cette face. Un tel résonateur comprend une base et deux bras vibrants généralement parallèles l'un de l'autre, et qui s'étendent dans une même direction depuis la base.

A ce titre, on peut citer le brevet FR 2 467 487, qui décrit un résonateur piézo-électrique à diapason. Comme représenté à la figure 1, ce résonateur 1 comprend une base 2 et deux bras vibrants 3, 3' s'étendant depuis la base. Au moins une rainure 4a, 4a', 4b, 4b' est réalisée sur une face inférieure et/ou une face supérieure de chaque bras 3, 3'. Ces bras présentent une section transversale en forme de H avec des rainures 4a, 4a', 4b, 4b' de même profondeur pour un agencement symétrique. Avec un agencement à électrodes non représentées et disposées en partie dans les rainures symétriques des bras, cela permet de diminuer la consommation d'énergie grâce à une excitation par un champ électrique plus homogène. Cependant le facteur de qualité n'est pas suffisamment amélioré.

Pour réduire encore les dimensions d'un tel résonateur piézo-électrique à diapason, tel que décrit dans le brevet US 6,587,009 B2, il est prévu de réaliser des encoches sur la base du résonateur pour permettre de découpler mécaniquement une zone de fixation du résonateur dans son boîtier et les bras vibrants fixés d'un autre côté de la base. De plus, des rainures sont encore réalisées sur chacun des bras du résonateur. Principalement, il est réalisé une rainure sur une face supérieure et une rainure sur une face inférieure de chaque bras, les deux rainures étant en regard l'une de l'autre. La profondeur des rainures est comprise entre 30 % et 50 % de l'épaisseur totale de chaque bras. Ces bras présentent également une section transversale en forme de H et de forme symétrique en négligeant l'asymétrie due à l'attaque chimique. Cependant avec un tel agencement des rainures dans chaque bras du résonateur, le facteur de qualité du résonateur est sujet à optimisation en faisant les rainures des deux faces de profondeur différente.

La demande de brevet US 2010/0277041 A1 décrit un résonateur piézo-électrique avec deux bras parallèles s'étendant depuis une base. Chaque bras comprend deux rainures parallèles réalisées côte à côte sur la longueur de chaque bras. Une première rainure est réalisée depuis une première face et d'une profondeur plus grande que 50 % de l'épaisseur du bras, alors qu'une seconde rainure est réalisée depuis une seconde face opposée et d'une profondeur plus grande que 50 % de l'épaisseur du bras. Les rainures sont agencées de manière symétrique et parallèles sur la longueur. Pour faire passer les deux rainures l'une à côté de l'autre, la largeur des rainures est limitée, ce qui rend défavorable le rapport largeur sur profondeur des rainures pour des bras de petite taille.

Le brevet US 7,626,318 B2 et la demande de brevet US 2013/0175903 A1 décrivent également un résonateur piézo-électrique avec au moins deux bras parallèles s'étendant depuis une base. Une rainure sur une face de dessus et une rainure sur une face de dessous dans chaque bras sont réalisées, mais avec une même profondeur donc selon une forme symétrique. Le facteur de qualité du résonateur est sujet à optimisation en faisant les rainures des deux faces de profondeur différente.

Le brevet US 8,400,049 B2 décrit un résonateur piézoélectrique avec deux bras parallèles s'étendant depuis une base. Deux rainures sur une face de dessus et deux rainures sur une face de dessous dans chaque bras sont réalisées avec des profondeurs et des largeurs différentes selon une forme asymétrique.

Un but principal de la présente invention est de permettre d'améliorer le facteur de qualité du résonateur à diapason sans compliquer la réalisation d'un tel résonateur de petite taille.

### RÉSUMÉ DE L'INVENTION

L'invention a donc pour but de proposer un résonateur piézo-électrique de petite taille pour pallier les inconvénients de l'état de la technique susmentionné, de manière à améliorer le facteur de qualité du résonateur sans compliquer la réalisation d'un tel résonateur.

A cet effet, l'invention concerne un résonateur piézo-électrique, qui comprend les caractéristiques mentionnées dans la revendication indépendante 1.

Des formes d'exécution du résonateur piézo-électrique sont définies dans des revendications dépendantes 2 à 16.

Un avantage du résonateur piézo-électrique réside dans le fait que chaque bras comprend au moins une rainure sur une face inférieure et/ou une rainure sur une face supérieure, dont la profondeur est de moins de 30 % de l'épaisseur de chaque bras ou de plus de 50 % de l'épaisseur de chaque bras.

Avantageusement, deux rainures en regard l'une de l'autre sur la face inférieure et sur la face supérieure de chaque bras sont réalisées. La première rainure a une profondeur d'un côté de moins de 30 % de l'épaisseur de chaque bras, et la seconde rainure a une profondeur d'un autre côté de plus de 50 %, voire d'au moins 65 % de l'épaisseur de chaque bras, ce qui donne deux rainures asymétriques.

Avantageusement en choisissant les surfaces appropriées pour réaliser les rainures profondes et peu profondes par rapport à l'orientation cristalline du résonateur, le facteur de qualité Q du résonateur s'est avéré amélioré par rapport au cas notamment de rainures symétriques. Grâce à cela, cela permet d'avoir une augmentation du facteur de qualité de près de 15 % par rapport à un résonateur de l'art antérieur.

### BRÈVE DESCRIPTION DES DESSINS

Les buts, avantages et caractéristiques du résonateur piézo-électrique apparaîtront mieux dans la description suivante par les dessins sur lesquels :
- la figure 1, déjà décrite, représente une vue de dessus d'un résonateur piézo-électrique à diapason présentant des rainures symétriques sur ses bras selon un art antérieur,
- les figures 2a et 2b représentent, selon deux formes d'exécution, une section transversale d'un des bras du résonateur piézo-électrique à diapason selon l'invention montrant la profondeur des rainures sur chaque bras,
- la figure 3 représente un graphique du facteur de qualité Q normalisé "courbe en traits pleins", référence à l'échelle au centre, ainsi que la composante de torsion en fonction de l'écart de profondeur des rainures entre la face inférieure et la face supérieure de chaque bras "courbe en traits interrompus", référence à l'échelle à droite,
- les figures 4a à 4g représentent une vue de dessus de différentes formes du résonateur piézo-électrique avec des rainures sur chaque bras à des profondeurs différentes comme indiquées aux figures 2a et 2b,
- la figure 5 représente schématiquement une coupe transversale d'un bras du résonateur piézo-électrique avec un agencement des électrodes pour expliquer le fonctionnement du résonateur piézo-électrique à rainures asymétriques selon l'invention, et
- les figures 6a à 6c représentent une vue de dessus et deux coupes longitudinales A-A et B-B de portions de bras d'une autre forme d'exécution semblable à la forme d'exécution présentée à la figure 4g du résonateur piézo-électrique avec des rainures sur chaque bras selon l'invention.

### DESCRIPTION DETAILLEE DE L'INVENTION

Dans la description suivante, toutes les parties du résonateur piézo-électrique, qui sont bien connues d'un homme du métier dans ce domaine technique, ne seront pas expliquées en détail. Il est encore à noter que la description suivante est donnée pour un résonateur piézo-électrique à diapason en quartz susceptible d'osciller principalement dans un mode fondamental de flexion. La définition des axes cristallins et des signes des coefficients élastiques suit la norme IEC 60758. Par conséquent, la description suivante s'applique de la même manière à un quartz dextrogyre et à un quartz lévogyre.

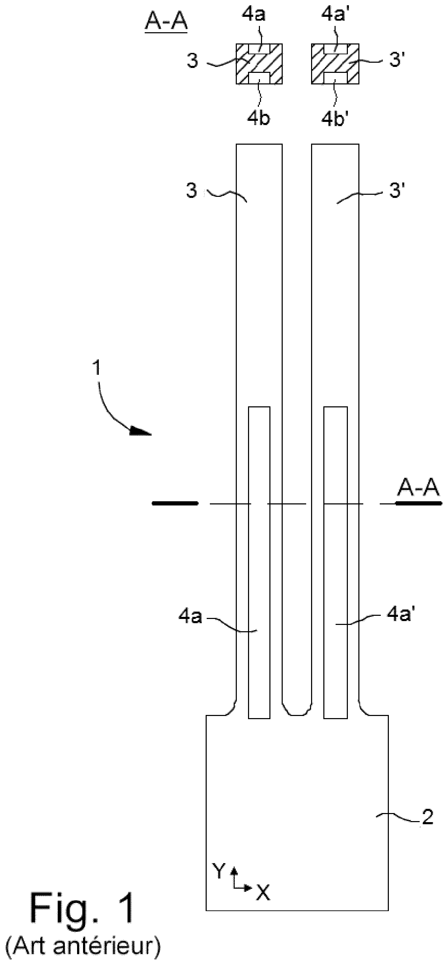

Le résonateur piézo-électrique 1 de la présente invention comprend, comme montré à la figure 1 de l'art antérieur, une base 2 et deux bras vibrants 3, 3' reliés à la base 2 dans une direction d'un axe cristallin X et s'étendant depuis la base dans une direction d'un axe cristallin Y ou -Y. L'orientation des axes principaux du résonateur peut dévier des axes cristallins de quelques degrés sans rien enlever aux effets décrits. De telles rotations de la coupe sont appliquées par exemple pour l'ajustage du comportement thermique du résonateur. Le résonateur piézo-électrique 1 est de préférence un résonateur à diapason avec deux bras 3, 3' susceptibles de vibrer pour la génération d'une oscillation.

Les deux bras sont généralement disposés depuis la base 2 en partie parallèles l'un par rapport à l'autre et par exemple de forme et dimensions similaires. Au moins une rainure 4a, 4a', 4b, 4b' est réalisée dans une direction d'un axe cristallin Z sur chaque bras 3, 3' depuis une face inférieure et/ou une face supérieure de chaque bras. De préférence, il est réalisé une rainure 4a, 4a' sur la face supérieure des deux bras 3, 3' et une rainure 4b, 4b' sur la face inférieure des deux bras 3, 3'. Les deux rainures réalisées dans chaque bras sont disposées en regard l'une par rapport à l'autre, mais de profondeur différente pour constituer des rainures asymétriques.

La face supérieure de chaque bras 3, 3' peut être dans le prolongement d'une face supérieure de la base 2, alors que la face inférieure de chaque bras 3, 3' peut être dans le prolongement d'une face inférieure de la base 2. Des bornes de connexion reliées à des électrodes disposées sur des faces des bras et non représentées, sont disposées sur la face inférieure de la base 2. Ces bornes de connexion sont traditionnellement fixées sur un échelon support de connexion lors du montage du résonateur dans un boîtier du composant électronique. Cependant il peut aussi être imaginé que l'épaisseur de la base 2 est plus petite ou plus grande que l'épaisseur de chaque bras 3, 3', qui est lié à la base 2.

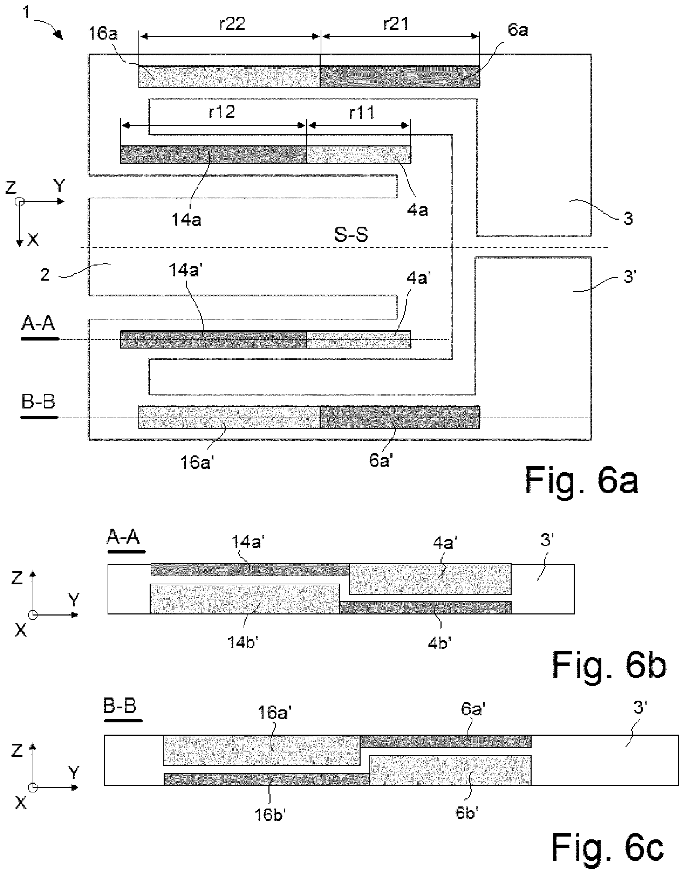

L'agencement des électrodes sur les bras peut être identique à l'agencement décrit au paragraphe 32 et montré à la figure 6A dans le brevet EP 1 633 042 B1.

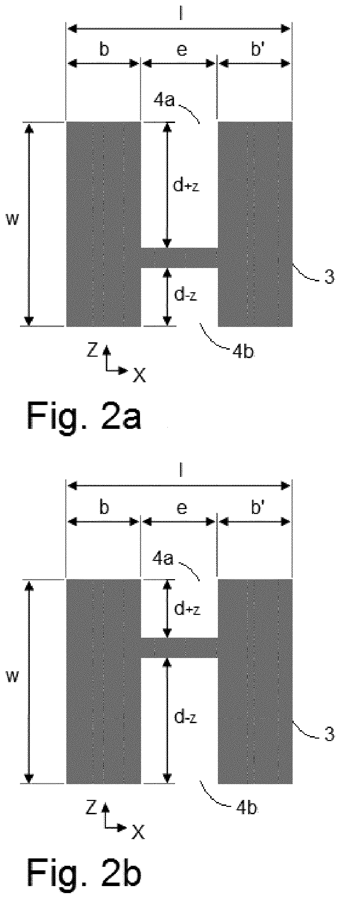

Comme représenté aux figures 2a et 2b, la profondeur d_{+z} de la rainure 4a sur la face supérieure de chaque bras 3 peut être différente de la profondeur d_{-z} de la rainure 4b sur la face inférieure de chaque bras 3. Il peut être déterminé une différence de profondeur r = d_{-z} - d_{+z}. Avec deux rainures asymétriques, une première rainure 4a a une profondeur inférieure à 30 % de l'épaisseur w de chaque bras 3, alors qu'une seconde rainure 4b a une profondeur supérieure à 50 %, ou inversement.

Selon une première variante montrée à la figure 2a, la profondeur d_{-z} est plus petite que la profondeur d_{+z}, ce qui donne la différence de profondeur r < 0 pour des rainures asymétriques. Selon une deuxième variante montrée à la figure 2b, la profondeur d_{-z} est plus grande que la profondeur d_{+z}, ce qui donne la différence de profondeur r > 0 pour des rainures asymétriques. La plus grande profondeur sur les figures 2a et 2b doit être plus grande que 50 % de l'épaisseur totale du bras et de préférence proche de 65 %, alors que la plus petite profondeur doit être plus petite que 30 % de l'épaisseur totale du bras et de préférence proche de 25 %. Il peut encore être envisagé d'avoir au maximum une profondeur de rainure d'un côté à 70 % de l'épaisseur du bras et de l'autre côté à 28 % de l'épaisseur du bras.

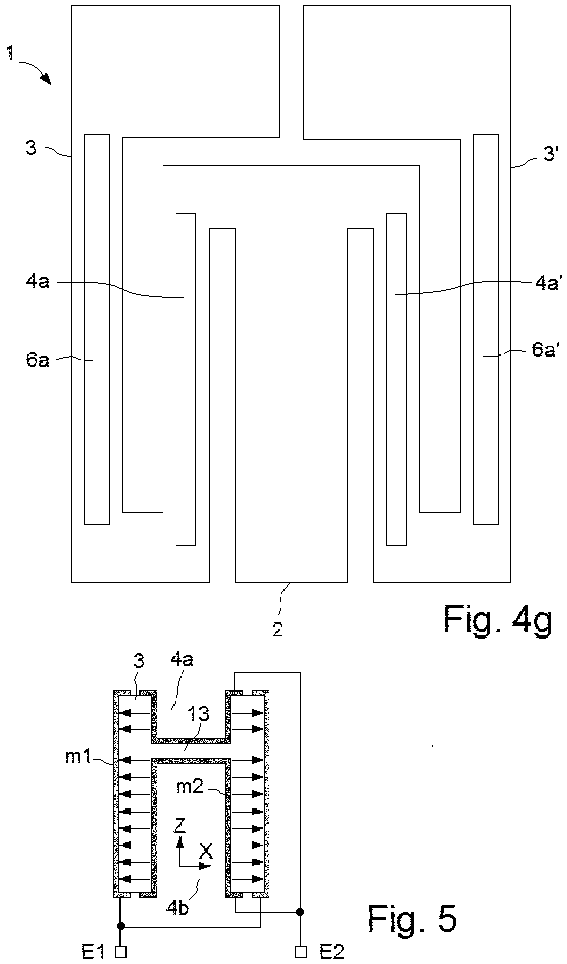

Dans ces conditions, il est particulièrement avantageux d'avoir une faible épaisseur de paroi de fond 13 comme montrée à la figure 5 également reliant la rainure à grande profondeur et la rainure à petite profondeur pour atténuer la transmission du stress lors de la compression d'un côté et l'extension de l'autre côté. Ceci permet d'atténuer la transmission de chaleur entre les deux côtés et ainsi d'obtenir un faible amortissement thermoélastique.

Les rainures 4a, 4a', 4b et 4b' de largeur e réalisées sur la face supérieure et sur la face inférieure de chaque bras 3, 3' sont de préférence situées centralement entre deux bords ou parois latérales b, b' de même largeur ou de largeur différente de chaque bras. A titre purement indicatif et sans limitation, la largeur l de chaque bras peut être de l'ordre de 52 µm, alors que l'épaisseur w peut être de l'ordre de 108 µm. Chaque bord ou paroi latérale b, b' peut être de l'ordre de 5 µm, ce qui fait que la largeur e de chaque rainure peut être de l'ordre de 42 µm. La longueur de chaque rainure peut être de l'ordre de 700 µm en partant depuis le bord de la base 2. La largeur de la base 2 peut être de l'ordre de 170 µm et la longueur de la base dans la direction des bras peut être de l'ordre de 770 µm. La longueur de chaque bras peut être de l'ordre de 1160 µm et l'espace entre les deux bras peut être de l'ordre de 330 µm.

Da manière générale, la longueur de chaque rainure le long de chaque bras peut être comprise entre 5 et 100 % de la longueur de chaque bras et la largeur de chaque rainure peut être comprise par exemple entre 40 et 90 % de la largeur de chaque bras.

Il peut être utilisé un autre matériau que le quartz pour réaliser le résonateur piézo-électrique. Il peut être pris un matériau, tel que AlPO4, GaPO4, GaAsO4, mais il est à noter, que les dimensions géométriques et l'orientation des premières et deuxièmes rainures par rapport aux axes cristallins peuvent être différentes de la situation décrite pour le quartz, car elles dépendent des coefficients élastiques du matériel, et en particulier du coefficient c14, qui doit être de signe négatif par référence à la norme IEC 60758 pour les orientations du résonateur décrites.

La différence de profondeur des coupes transversales d'un des bras des figures 2a et 2b, est donc montrée pour un bras s'étendant dans la direction +Y (référencée par la suite comme orientation (X, +Y)). Si on change l'orientation des bras montrés à la figure 1 dans la direction -Y selon l'orientation cristalline (référencée par la suite comme orientation (X, -Y)), la rainure profonde aux figures 2a et 2b changent de côté.

En raison de la nature anistropique du quartz cristallin, si on a un profil symétrique des bras du résonateur, cela génère une composante spatiale de torsion autour de l'axe Y, qui se superpose au mode de flexion dans la direction X. Cette composante de torsion peut être supprimée ou favorisée en cassant la symétrie du profil de la poutre (bras). Parmi d'autres moyens et comme indiqué ci-dessus, ceci peut être effectué en changeant r = d_{-z} - d_{+z} en des valeurs différentes de 0 comme montré aux figures 2a et 2b, où d_{-z} est la profondeur de la rainure 4b, 4b' sur la face inférieure (côté -Z) de chaque bras 3, 3' par rapport à l'épaisseur de chaque bras, et d_{+z} est la profondeur de la rainure 4a, 4a' sur la face supérieure (côté +Z) par rapport à l'épaisseur de chaque bras.

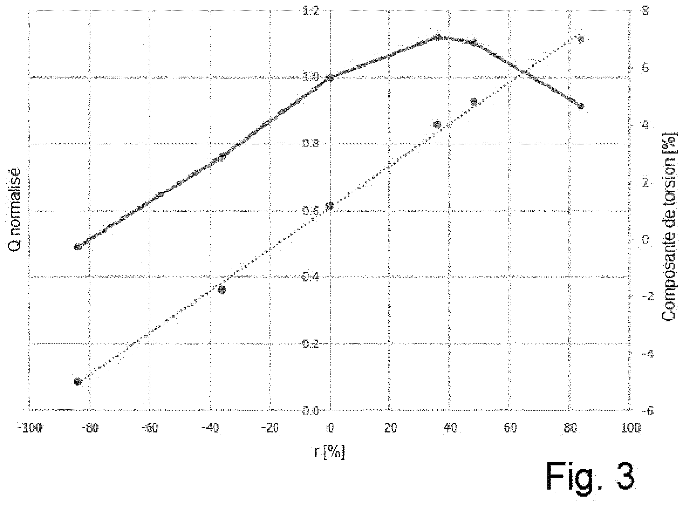

Comme représenté sur les figures 2a et 2b, des études numériques ont montré que le facteur de qualité Q diminue pour r < 0 et augmente pour r > 0 pour l'orientation cristalline (X, +Y) du résonateur. A cette valeur de r > 0, le facteur de qualité atteindra un maximum et diminuera à nouveau même pour r plus grand. A la figure 3, le facteur de qualité normalisé Q est montré en traits pleins en dépendance de r. Ce facteur de qualité Q est vu pour avoir un pic autour de r = 0.4, ce qui correspond à d_{-z} environ à 65% et d_{+z} environ à 25%. La valeur de r, à laquelle le maximum du facteur de qualité Q est atteint, dépend de la géométrie précise du profil des bras, et spécialement de la largeur de chaque bord b, b' entre la rainure de largeur e et la paroi latérale du bras.

Le comportement observé peut être expliqué par la génération d'une composante de torsion montrée selon la ligne pointillée en figure 3 et superposée au mode de flexion, qui modifie la distribution du stress dans les bras du résonateur. Il en résulte une décroissance de l'amortissement thermoélastique pour r > 0 qui ainsi augmente le facteur de qualité Q au moins jusqu'à la valeur r = 40 %.

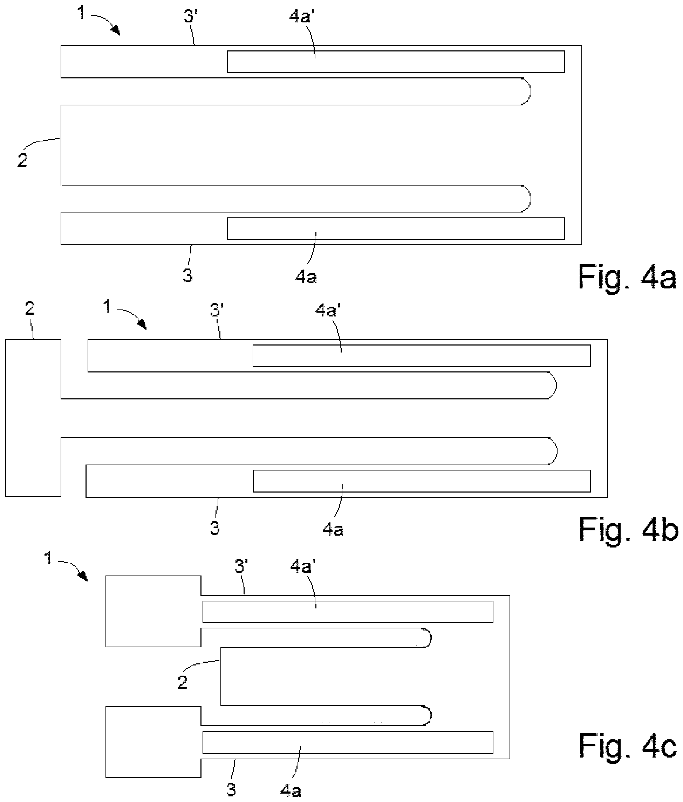

Différentes formes du résonateur piézo-électrique 1 sont montrées aux figures 4a à 4g, dans lesquelles la forme des bras et des rainures est modifiée tout en gardant la profondeur d'une des rainures 4a, 4a' plus petite que la profondeur de l'autre rainure en regard non représentée. Selon l'orientation cristalline (X, +Y), les rainures 4a et 4a' sur la face supérieure ont une profondeur proche de 25% de l'épaisseur du bras, alors que les rainures sur la face inférieure ont une profondeur proche de 65% de l'épaisseur du bras. Ces rainures avec les profondeurs comme montrées aux figures 2a et 2b se retrouvent dans chaque forme d'exécution du résonateur montrée aux figures 4a à 4g.

La figure 4a représente une vue de dessus d'un résonateur piézo-électrique 1 avec les deux bras vibrants 3, 3' liés à la base 2 par l'intermédiaire d'une partie de liaison. La base 2 est située entre les deux bras vibrants 3, 3' et parallèle aux deux bras 3, 3'. Chaque bras 3, 3' comprend une rainure 4a, 4a' sur la face supérieure et une rainure sur la face inférieure non représentée et en regard de la rainure sur la face supérieure. Les rainures sont réalisées sur une partie de la longueur de chaque bras et partant depuis la partie de liaison à la base 2.

La figure 4b représente une vue de dessus d'un résonateur piézo-électrique 1 avec les deux bras vibrants 3, 3' liés à la base 2 par l'intermédiaire d'une partie de liaison. Ce résonateur piézo-électrique est similaire à celui représenté à la figure 4a avec un même agencement des rainures 4a, 4a' excepté que la base 2 comprend encore une partie d'extrémité de fixation d'un côté opposé à la partie de liaison des bras 3, 3' à la base 2. Dans ce cas de figure, la base 2 est plus longue que les bras 3, 3'.

La figure 4c représente une vue de dessus d'un résonateur piézo-électrique 1 avec les deux bras vibrants 3, 3' liés à la base 2 par l'intermédiaire d'une partie de liaison. Ce résonateur piézo-électrique est similaire à celui représenté à la figure 4a ou à la figure 4b avec un même agencement des rainures 4a, 4a'. A la différence des formes d'exécution représentées aux figures 4a et 4b, la longueur de la base 2 est plus petite que la longueur des bras vibrants 3, 3'. Chaque bras 3, 3' se termine d'un côté opposé à la partie de liaison des bras 3, 3' à la base 2 par une palme de forme rectangulaire symétrique.

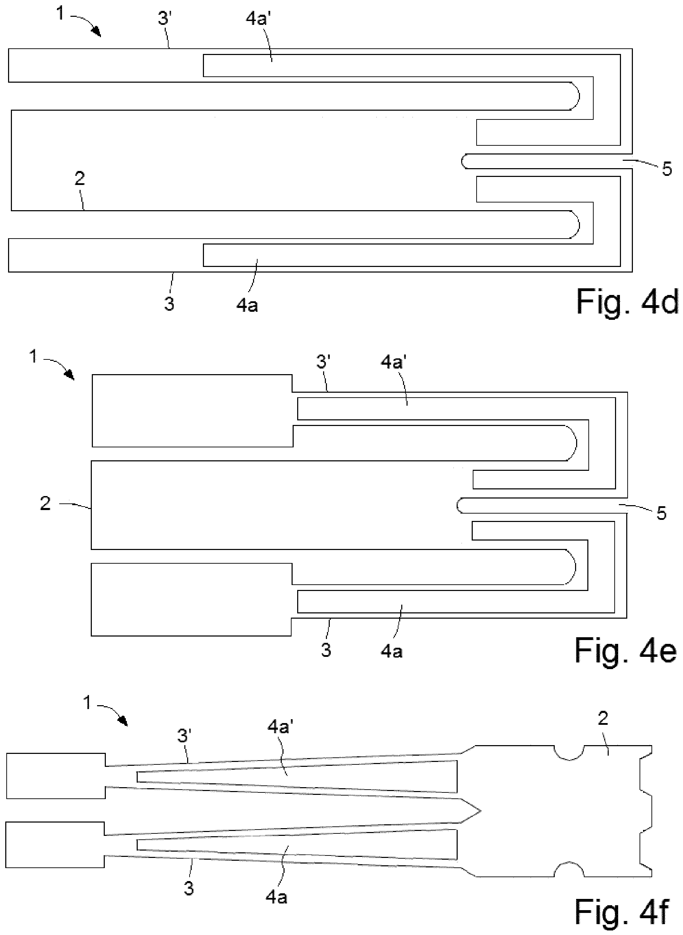

La figure 4d représente une vue de dessus d'un résonateur piézo-électrique 1 avec les deux bras vibrants 3, 3' liés à la base 2 par l'intermédiaire d'une partie de liaison. La forme générale du résonateur correspond à celle du résonateur représenté à la figure 4a. La partie de liaison comprend encore une fente 5 dans la direction Y. Cela a pour effet d'agrandir les deux bras 3, 3' en liaison à la base 2 tout en gardant une dimension réduite dudit résonateur. Une rainure 4a, 4a' sur la face supérieure et une rainure sur la face inférieure de chaque bras sont prévues en s'étendant également sur la partie de liaison à la base 2. En vue de dessus chaque rainure à la forme d'un U.

La figure 4e représente une vue de dessus d'un résonateur piézo-électrique 1 avec les deux bras vibrants 3, 3' liés à la base 2 par l'intermédiaire d'une partie de liaison. Cette forme d'exécution est similaire à celle représentée à la figure 4d excepté qu'il est encore prévu une palme à l'extrémité de chaque bras 3, 3' se terminant d'un côté opposé à la partie de liaison des bras 3, 3' à la base 2. Chaque palme peut avoir par exemple une forme rectangulaire symétrique ou une autre forme non représentée sans limitation spécifique à cette forme présentée.

La figure 4f représente une vue de dessus d'un résonateur piézo-électrique 1 avec deux bras vibrants 3, 3' liés à la base 2 de manière similaire à ce qui est représenté à la figure 1. Cependant, chacun des deux bras 3, 3' a une largeur, qui se réduit en continu de manière linéaire depuis la base 2 et jusqu'à son extrémité libre, qui se termine encore par une palme de forme rectangulaire et symétrique. Chaque rainure 4a, 4a' réalisée sur la face supérieure et sur la face inférieure de chaque bras 3, 3' a également une largeur, qui se réduit en continu de manière linéaire depuis la base 2 et jusqu'à une partie du bras avant chaque palme. Bien entendu, la profondeur des rainures 4a, 4a' sur la face supérieure est différente de la profondeur des rainures sur la face inférieure. De plus, la profondeur des rainures 4a, 4a' diminue de la base 2 à l'extrémité libre de chaque bras 3, 3' tout en maintenant une des rainures à une profondeur plus petite de 30 % de l'épaisseur du bras et l'autre des rainures à une profondeur plus grande de 50 % de l'épaisseur du bras. Des encoches peuvent encore être prévues dans la base 2 pour améliorer le découplage mécanique entre les bras vibrants 3, 3' et la partie fixe de la base 2.

La figure 4g représente une vue de dessus d'un résonateur piézo-électrique 1 avec les deux bras vibrants 3, 3' liés à la base 2 par l'intermédiaire d'une partie de liaison comme montré en partie à la figure 4a. Chaque bras 3, 3' comprend une première portion allongée reliée à la base par une partie de liaison. La première portion allongée est parallèle à la base 2 et s'étend sur toute la longueur de la base 2. Chaque bras 3, 3' comprend encore une seconde portion allongée parallèle à la première portion qui est reliée à la première portion allongée par une partie transversale. La seconde portion de chaque bras 3, 3' se termine par une palme de forme rectangulaire, qui s'étend de manière symétrique vers la base 2, et en étant parallèle à la partie de liaison. Une première rainure 4a, 4a' est réalisée sur la face supérieure de la première portion de chaque bras 3, 3', et une troisième rainure 6a, 6a' est réalisée sur la face supérieure de la seconde portion de chaque bras 3, 3'. Des secondes et quatrièmes rainures sont également réalisées sur la face inférieure des première et seconde portions de chaque bras 3, 3', et en regard respectivement des premières et troisièmes rainures réalisées depuis la face supérieure. La profondeur des premières et troisièmes rainures 4a, 4a', 6a, 6a' peut être identique ou différente, et il en est de même pour les secondes et quatrièmes rainures.

Il est encore à noter que sur les formes d'exécution présentées aux figures 4a à 4g, il peut aussi être envisagé d'avoir chaque bras avec deux rainures parallèles de petite dimension sur chaque face supérieure et inférieure tout en garantissant une rainure 4a, 4a' sur la face supérieure de profondeur différente de la profondeur de la rainure sur la face inférieure.

La figure 5 représente schématiquement une coupe transversale d'un bras 3 du résonateur piézo-électrique, qui comprend une rainure 4a réalisée depuis la face supérieure du bras 3 et une rainure 4b réalisée depuis la face inférieure du bras 3. La rainure 4a sur la face supérieure est de préférence d'une profondeur plus petite que la profondeur de la rainure 4b sur la face inférieure pour une orientation (X, +Y) du résonateur selon les axes cristallins pour le cas du quartz. Une paroi de fond 13 de faible épaisseur est réalisée au fond des rainures du bras 3 reliant les parois latérales du bras.

Des électrodes m1 et m2 sont réalisées sur des faces de chaque bras. Ces électrodes sont généralement des électrodes métalliques. Une première électrode m1 est par exemple réalisée sur les faces latérales du bras, alors qu'une seconde électrode m2 est par exemple réalisée dans les rainures 4a et 4b. Selon cet agencement des électrodes m1, m2 et la forme du bras 3 avec les rainures 4a, 4b, cela constitue une forme de condensateur plan.

La première électrode m1 est reliée à une première borne de connexion électrique E1, alors que la seconde électrode m2 est reliée à une seconde borne de connexion électrique E2 dans un circuit oscillateur. Une différence de tension électrique variable dans le temps est appliquée aux bornes E1 et E2 lors du fonctionnement du résonateur, ce qui génère un champ électrique variable entre les électrodes m1 et m2 à une fréquence de résonance définie.

Ainsi comme représenté en figure 5 et selon l'orientation cristalline du résonateur à quartz, un stress est généré, car il y a un couplage entre le champ électrique et le stress mécanique. Par conséquent, une des faces ou parois latérales est en compression, alors que l'autre face ou paroi latérale est en extension, ce qui génère de la chaleur. Avec la paroi mince de fond 13, qui relie les deux parois latérales du bras 3, cela permet d'atténuer la relaxation thermique, et ainsi les pertes thermodynamiques lors de la compression d'un côté et l'extension de l'autre côté. On obtient ainsi une augmentation du facteur de qualité Q avec les profondeurs adaptées des rainures 4a, 4b.

Il est encore à noter que le résonateur à quartz est défini entre les deux bornes de connexion électriques E1 et E2 par une résistance en série avec un premier condensateur, et une inductance. Un second condensateur parasite est agencé en parallèle de l'ensemble constitué de la résistance, du premier condensateur, et de l'inductance. La résistance représente des pertes, qui doivent être limitées, alors que le premier condensateur doit être de grande valeur pour améliorer le couplage électrique.

La figure 6a représente une vue de dessus d'un résonateur piézo-électrique 1 avec les deux bras vibrants 3, 3' liés à la base 2 comme une variante de réalisation montrée à la figure 4g. De plus, les figures 6b et 6c représentent des vues en coupe longitudinale A-A et B-B de première et seconde portions allongées d'un des bras du résonateur montré à la figure 6a.

Comme expliqué précédemment en référence à la figure 4g, chaque bras 3, 3' comprend une première portion allongée reliée à la base par une partie de liaison. La première portion allongée est parallèle à la base 2. Chaque bras 3, 3' comprend encore une seconde portion allongée parallèle à la première portion qui est reliée à la première portion allongée par une partie transversale. La seconde portion de chaque bras 3, 3' peut se terminer par une palme de forme rectangulaire, qui s'étend de manière symétrique vers la base 2, et en étant parallèle à la partie de liaison.

Sur la figure 6a, une première rainure 4a, 4a' d'une première profondeur et une première rainure complémentaire 14a, 14a' d'une seconde profondeur différente de la première profondeur sont réalisées sur la face supérieure de la première portion de chaque bras 3, 3'. Une troisième rainure 6a, 6a' d'une seconde profondeur et une troisième rainure complémentaire 16a, 16a' d'une première profondeur différente de la seconde profondeur sont réalisées sur la face supérieure de la seconde portion de chaque bras 3, 3'. Des seconde et quatrième rainures et des seconde et quatrième rainures complémentaires sont également réalisées sur la face inférieure des première et seconde portions de chaque bras 3, 3' en regard respectivement des première et troisième rainures 4a, 4a', 6a, 6a' et des première et troisième rainures complémentaires 14a, 14a', 16a, 16a' sur la face supérieure.

La première profondeur de rainure peut être choisie à plus de 50 % de l'épaisseur de chaque bras, et la seconde profondeur de rainure peut être choisie à moins de 30 % de l'épaisseur de chaque bras. Bien entendu, il peut être envisagé d'avoir la première profondeur de rainure à moins de 30 % de l'épaisseur de chaque bras et la seconde profondeur à plus de 50 % de l'épaisseur de chaque bras.

Les figures 6b, 6c représentent des vues en coupe longitudinale A-A et B-B respectivement de la première portion et de la seconde portion du bras 3'. La première portion comprend la première rainure 4a' et la première rainure complémentaire 14a', qui forment une rainure continue ou segmentée sur la face supérieure, mais avec des profondeurs différentes. La première portion comprend encore sur la face inférieure une seconde rainure 4b' et une seconde rainure complémentaire 14b', qui forment aussi une rainure continue ou segmentée sur la face inférieure, mais avec des profondeurs différentes. La seconde rainure 4b' est réalisée à une seconde profondeur si la première rainure 4a' est à une première profondeur, alors que la seconde rainure complémentaire 14b' est réalisée à une première profondeur si la première rainure complémentaire 14a' est à une seconde profondeur. Dans ce cas de figure, la première profondeur est à plus de 50 % de l'épaisseur du bras 3', alors que la seconde profondeur est à moins de 30 % de l'épaisseur du bras 3'. Ainsi, la longueur de la première rainure 4a' doit être plus petite que la longueur de la seconde rainure 4b', alors que la longueur de la première rainure complémentaire 14a' doit être plus grande que la longueur de la seconde rainure complémentaire 14b'.

La seconde portion comprend la troisième rainure 6a' et la troisième rainure complémentaire 16a', qui forment une rainure continue ou segmentée sur la face supérieure, mais avec des profondeurs différentes. La seconde portion comprend encore sur la face inférieure une quatrième rainure 6b' et une quatrième rainure complémentaire 16b', qui forment aussi une rainure continue ou segmentée sur la face inférieure. La quatrième rainure 6b' est réalisée à une première profondeur si la troisième rainure 6a' est à une seconde profondeur, alors que la quatrième rainure complémentaire 16b' est réalisée à une seconde profondeur si la seconde rainure complémentaire 16a' est à une première profondeur. Dans ce cas de figure, la première profondeur est à plus de 50 % de l'épaisseur du bras 3', alors que la seconde profondeur est à moins de 30 % de l'épaisseur du bras 3'. Ainsi, la longueur de la troisième rainure 6a' doit être plus grande que la longueur de la quatrième rainure 6b', alors que la longueur de la troisième rainure complémentaire 16a' doit être plus petite que la longueur de la quatrième rainure complémentaire 16b'.

Un avantage de réaliser ce type de rainures sur les bras 3, 3' du résonateur, est qu'en ajustant le rapport des longueurs des différentes rainures des portions de chaque bras la composante de torsion du mode de flexion fondamental peut être modifié pour maximiser le facteur de qualité Q indépendamment des relations géométriques transversales des bras. C'est d'intérêt particulier en regard des largeurs des bords b, b' et leur relation à la largeur de rainure e, à la largeur de chaque bras l et à l'épaisseur w du bras, montré aux figures 2a et 2b, qui peuvent influencer la capacité motionelle C1, qui est la capacité dans la branche de résonance par opposition à la capacité statique C0. Cette technique était trouvée particulièrement efficace pour un résonateur tel que proposé à la figure 4g, mais il peut être envisagé d'appliquer un même type de rainures sur les bras des résonateurs des figures 4a à 4g.

En regard de la figure 6a, il est représenté la longueur des différentes rainures réalisées notamment depuis la face supérieure sur les deux portions de chaque bras 3, 3'. Les premières rainures 4a, 4a' avec les premières rainures complémentaires 14a, 14a', et les troisièmes rainures 6a, 6a' avec les troisièmes rainures complémentaires 16a, 16a' sont définies avec les références de longueur r11, r12, r21, r22. La référence de longueur r11 se rapporte aux premières rainures 4a, 4a', et la référence de longueur r12 se rapporte aux premières rainures complémentaires 14a, 14a'. La référence de longueur r21 se rapporte aux troisièmes rainures 6a, 6a', et la référence de longueur r22 se rapporte aux troisièmes rainures complémentaires 16a, 16a'. Les rapports de longueur r12/r11 et r22/r21 peuvent ne pas être égaux et sont choisis de telle manière à optimiser la composante de torsion au maximum du facteur de qualité Q comme représenté sur le graphe de la figure 3 et expliqué ci-devant.

Comme représenté à la figure 6a, les longueurs r11, r12, r21 et r22 peuvent être légèrement différentes sur la face supérieure et également sur la face inférieure pour les secondes et quatrièmes rainures et secondes et quatrièmes rainures complémentaires, non représentées à la figure 6a. Ceci est nécessaire pour éviter la pénétration de la paroi mince de fond 13 à la jonction des rainures réalisées depuis la face supérieure et depuis la face inférieure de chaque bras 3, 3' et comme expliqué ci-dessus en référence aux figures 6b et 6c. De plus, il peut être imaginé de séparer par une section réduite en profondeur, non représentée, les premières rainures 4a, 4a' des premières rainures complémentaires 14a, 14a', les secondes rainures des secondes rainures complémentaires, les troisièmes rainures 6a, 6a' des troisièmes rainures complémentaires 16a, 16a', et les quatrièmes rainures des quatrièmes rainures complémentaires. Dans l'exemple montré à la figure 6a, les rainures sont agencées symétriquement par rapport au plan de symétrie Y-Z S-S. Bien entendu, il peut être aussi imaginé d'inverser la profondeur des rainures par rapport aux axes Z et Y, et aussi bien par rapport aux première et secondes portions des bras en comparaison à ce qui est montré à la figure 6a. Il peut encore être imaginé de rajouter en continuité à chaque rainure des faces supérieure et inférieure des bras d'autres rainures complémentaires de profondeur différente en respectant une profondeur plus petite que 30 % ou plus grande que 50 % de l'épaisseur de chaque bras.

A partir de la description qui vient d'être faite de multiples variantes de réalisation du résonateur piézo-électrique peuvent être conçues par l'homme du métier sans sortir du cadre de l'invention définie par les revendications. La longueur des bras peut être différente l'un de l'autre. Il peut être prévu des rainures de forme différente sur chaque bras avec des profondeurs et/ou des largeurs variant sur la longueur des bras progressivement ou par paliers.

## Revendications

1. Résonateur piézo-électrique (1) à quartz ayant les axes cristallins X, Y, Z et comprenant une base (2) et au moins deux bras vibrants (3, 3') reliés à la base (2) dans une direction d'un axe cristallin X, pour lequel les bras vibrants (3, 3') s'étendent depuis la base dans une direction d'un axe cristallin +Y ou -Y, pour lequel une première rainure (4a, 4a') est formée sur une face supérieure sur un côté +Z de chaque bras (3, 3') selon l'axe cristallin +Y ou -Y sur une partie de la longueur des bras (3, 3') et pour lequel une seconde rainure (4b, 4b') est formée sur une face inférieure sur un côté -Z de chaque bras (3, 3') selon ledit axe cristallin +Y ou -Y sur une partie de la longueur des bras (3, 3') et en regard de la première rainure (4a, 4a'), où la première et la seconde rainure sont formées avec des profondeurs différentes, **caractérisé en ce que** la profondeur de la première rainure (4a, 4a') est inférieure à 30 % de l'épaisseur totale de chaque bras (3, 3') ou supérieure à 50 % de l'épaisseur totale de chaque bras (3, 3'),
**en ce que** la profondeur de la seconde rainure (4b, 4b') est supérieure à 50 % de l'épaisseur totale de chaque bras (3, 3'), si la profondeur de la première rainure (4a, 4a') est inférieure à 30 % de l'épaisseur totale de chaque bras (3, 3'), ou inférieure à 30 % de l'épaisseur totale de chaque bras (3, 3'), si la profondeur de la première rainure (4a, 4a') est supérieure à 50 % de l'épaisseur totale de chaque bras (3, 3'), et
**en ce que** la largeur de chaque rainure (4a, 4a', 4b, 4b') est comprise entre 40 et 90 % de la largeur de chaque bras (3, 3').

2. Résonateur piézo-électrique (1) selon la revendication 1, pour lequel les bras vibrants (3, 3') sont reliés à la base (2) dans une direction d'un axe cristallin X, pour lequel les bras vibrants (3, 3') s'étendent depuis la base dans une direction d'un axe cristallin +Y, pour lequel la première rainure (4a, 4a') est formée sur la face supérieure sur un côté +Z de chaque bras (3, 3') selon l'axe cristallin +Y, pour lequel la seconde rainure (4b, 4b') est formée sur la face inférieure sur un côté -Z de chaque bras (3, 3') selon l'axe cristallin +Y, **caractérisé en ce que** la profondeur de la première rainure (4a, 4a') est inférieure à 30 % de l'épaisseur totale de chaque bras (3, 3'), et **en ce que** la profondeur de la seconde rainure (4b, 4b') est supérieure à 50 % de l'épaisseur totale de chaque bras (3, 3').

3. Résonateur piézo-électrique (1) selon la revendication 2, **caractérisé en ce que** la première rainure (4a, 4a') a une profondeur de l'ordre de 25 % de l'épaisseur totale de chaque bras (3, 3'), et **en ce que** la seconde rainure (4b, 4b') a une profondeur de l'ordre de 65 % de l'épaisseur totale de chaque bras (3, 3').

4. Résonateur piézo-électrique (1) selon la revendication 1, pour lequel les bras vibrants (3, 3') sont reliés à la base (2) dans une direction d'un axe cristallin X, pour lequel les bras vibrants (3, 3') s'étendent depuis la base dans une direction d'un axe cristallin -Y, pour lequel la première rainure (4a, 4a') est formée sur la face supérieure sur un côté +Z de chaque bras (3, 3') selon l'axe cristallin -Y, pour lequel la seconde rainure (4b, 4b') est formée sur la face inférieure sur un côté -Z de chaque bras (3, 3') selon l'axe cristallin -Y, **caractérisé en ce que** la profondeur de la première rainure (4a, 4a') est supérieure à 50 % de l'épaisseur totale de chaque bras (3, 3'), et **en ce que** la profondeur de la seconde rainure (4b, 4b') est inférieure à 30 % de l'épaisseur totale de chaque bras (3, 3').

5. Résonateur piézo-électrique (1) selon la revendication 4, **caractérisé en ce que** la première rainure (4a, 4a') a une profondeur de l'ordre de 65 % de l'épaisseur totale de chaque bras (3, 3'), et **en ce que** la seconde rainure (4b, 4b') a une profondeur de l'ordre de 25 % de l'épaisseur totale de chaque bras (3, 3').

6. Résonateur piézo-électrique (1) selon la revendication 1, **caractérisé en ce que** la largeur de chaque rainure (4a, 4a', 4b, 4b') est de l'ordre de 42 µm, et **en ce que** la largeur de chaque bras (3, 3') est de l'ordre de 52 µm.

7. Résonateur piézo-électrique (1) selon la revendication 1, **caractérisé en ce que** chaque rainure (4a, 4a', 4b, 4b') est centrée sur la longueur de chaque bras (3, 3').

8. Résonateur piézo-électrique (1) selon l'une des revendications précédentes, **caractérisé en ce que** la longueur de chaque rainure (4a, 4a', 4b, 4b') est comprise entre 5 et 100 % de la longueur de chaque bras (3, 3').

9. Résonateur piézo-électrique (1) selon la revendication 8, **caractérisé en ce que** la longueur de chaque rainure (4a, 4a', 4b, 4b') est de l'ordre de 700 µm, et **en ce que** la longueur de chaque bras (3, 3') depuis la base (2) est de l'ordre de 1160 µm.

10. Résonateur piézo-électrique (1) selon la revendication 9, **caractérisé en ce qu'**un espace entre chaque bras (3, 3') est de 330 µm.

11. Résonateur piézo-électrique (1) selon la revendication 1, **caractérisé en ce que** le résonateur est un résonateur à diapason à quartz avec deux bras (3, 3') de même longueur depuis la base (2), et dont au moins deux portions des bras (3, 3') sont disposées parallèles l'une par rapport à l'autre.

12. Résonateur piézo-électrique (1) selon la revendication 1, **caractérisé en ce que** la base (2) et les deux bras (3, 3') sont de même épaisseur.

13. Résonateur piézo-électrique (1) selon la revendication 1, **caractérisé en ce que** chaque rainure (4a, 4a', 4b, 4b') a une profondeur et/ou une largeur variant sur la longueur de chaque bras (3, 3'), progressivement ou par paliers.

14. Résonateur piézo-électrique (1) selon la revendication 1, pour lequel le résonateur comprend une première portion allongée de chaque bras (3, 3') reliée à la base (2) par une partie de liaison et parallèle à la base (2), et une seconde portion allongée de chaque bras (3, 3') parallèle à la première portion, qui est reliée à la première portion allongée par une partie transversale orientée dans la direction de l'axe X, **caractérisé en ce que** le résonateur comprend la première rainure (4a, 4a') d'une première profondeur et une première rainure complémentaire (14a, 14a') d'une seconde profondeur différente de la première profondeur réalisées sur la face supérieure de la première portion de chaque bras (3, 3'), **en ce qu'**il comprend une troisième rainure (6a, 6a') ayant la d'une seconde profondeur et une troisième rainure complémentaire (16a, 16a') ayant la première profondeur réalisées sur la face supérieure de la seconde portion de chaque bras (3, 3'), **en ce qu'**il comprend la seconde rainure (4b, 4b') ayant la seconde profondeur et une seconde rainure complémentaire (14b, 14b') ayant la première profondeur réalisées sur une face inférieure de la première portion de chaque bras (3, 3') en regard respectivement des première rainure (4a, 4a') et première rainure complémentaire (14a, 14a') de la face supérieure de la première portion de chaque bras (3, 3'), **en ce qu'**il comprend une quatrième rainure (6b, 6b') ayant la première profondeur et une quatrième rainure complémentaire (16b, 16b') ayant la seconde profondeur réalisées sur la face inférieure de la seconde portion de chaque bras (3, 3') en regard respectivement des troisième rainure (6a, 6a') et troisième rainure complémentaire (16a, 16a') de la face supérieure de la seconde portion de chaque bras (3, 3'), et **en ce que** la première profondeur est supérieure à 50 % de l'épaisseur totale de chaque bras, et la seconde profondeur est inférieure à 30 % de l'épaisseur totale de chaque bras, ou la première profondeur est inférieure à 30 % de l'épaisseur totale de chaque bras, et la seconde profondeur est supérieure à 50 % de l'épaisseur totale de chaque bras, où chaque rainure forme avec la rainure complémentaire correspondante une rainure continue ou segmentée rangée du même côté de leur bras commun.

15. Résonateur piézo-électrique (1) selon la revendication 1, pour lequel le résonateur comprend une première portion allongée de chaque bras (3, 3') reliée à la base (2) par une partie de liaison et parallèle à la base (2), et une seconde portion allongée de chaque bras (3, 3') parallèle à la première portion, qui est reliée à la première portion allongée par une partie transversale orientée dans la direction de l'axe X, **caractérisé en ce que** le résonateur comprend la première rainure (4a, 4a') d'une première profondeur et une première rainure complémentaire (14a, 14a') d'une seconde profondeur différente de la première profondeur réalisées sur la face supérieure de la première portion de chaque bras (3, 3'), **en ce qu'**il comprend une troisième rainure (6a, 6a') ayant la première profondeur et une troisième rainure complémentaire (16a, 16a') ayant la seconde profondeur réalisées sur la face supérieure de la seconde portion de chaque bras (3, 3'), **en ce qu'**il comprend la seconde rainure (4b, 4b') ayant la seconde profondeur et une seconde rainure complémentaire (14b, 14b') ayant la première profondeur réalisées sur une face inférieure de la première portion chaque bras (3, 3') en regard respectivement des première rainure (4a, 4a') et première rainure complémentaire (14a, 14a') de la face supérieure de chaque première portion de bras, **en ce qu'**il comprend une quatrième rainure (6b, 6b') ayant la seconde profondeur et une quatrième rainure complémentaire (16b, 16b') ayant la première profondeur réalisées sur la face inférieure de la seconde portion de chaque bras (3, 3') en regard respectivement des troisième rainure (6a, 6a') et troisième rainure complémentaire (16a, 16a') de la face supérieure de la seconde portion de chaque bras (3, 3'), et **en ce que** la première profondeur est supérieure à 50 % de l'épaisseur totale de chaque bras, et la seconde profondeur est inférieure à 30 % de l'épaisseur totale de chaque bras, ou la première profondeur est inférieure à 30 % de l'épaisseur totale de chaque bras, et la seconde profondeur est supérieure à 50 % de l'épaisseur totale de chaque bras, où chaque rainure forme avec la rainure complémentaire correspondante une rainure continue ou segmentée rangée du même côté de leur bras commun.

16. Résonateur piézo-électrique (1) selon la revendication 14 ou 15, **caractérisé en ce que** d'autres première, seconde, troisième et quatrième rainures complémentaires d'une première ou seconde profondeur par rapport à l'épaisseur totale de chaque bras (3, 3'), sont prévues en continu ou par segments de chaque rainure réalisée sur les portions de chaque bras.

## Patentansprüche

1. Piezoelektrischer Resonator (1) mit Quarz, der die Kristallachsen X, Y, Z aufweist und eine Basis (2) und mindestens zwei Schwingarme (3, 3') umfasst, die mit der Basis (2) in einer Richtung einer X-Kristallachse verbunden sind, wobei sich die Schwingarme (3, 3') ausgehend von der Basis in einer Richtung einer +Y- oder -Y-Kristallachse erstrecken, wobei eine erste Nut (4a, 4a') auf einer oberen Fläche auf einer +Z-Seite jedes Arms (3, 3') gemäß der +Y- oder -Y-Kristallachse auf einem Teil der Länge der Arme (3, 3') gebildet ist und wobei eine zweite Nut (4b, 4b') auf einer unteren Fläche auf einer -Z-Seite jedes Arms (3, 3') gemäß der +Y- oder -Y-Kristallachse auf einem Teil der Länge der Arme (3, 3') und gegenüber der ersten Nut (4a, 4a') gebildet ist, wobei die erste und zweite Nut mit unterschiedlichen Tiefen gebildet sind,
**dadurch gekennzeichnet, dass** die Tiefe der ersten Nut (4a, 4a') geringer ist als 30 % der Gesamtdicke jedes Arms (3, 3') oder größer ist als 50 % der Gesamtdicke jedes Arms (3, 3'),
dadurch, dass die Tiefe der zweiten Nut (4b, 4b') größer ist als 50 % der Gesamtdicke jedes Arms (3, 3'), wenn die Tiefe der ersten Nut (4a, 4a') geringer ist als 30 % der Gesamtdicke jedes Arms (3, 3'), oder geringer als 30 % der Gesamtdicke jedes Arms (3, 3'), wenn die Tiefe der ersten Nut (4a, 4a') größer ist als 50 % der Gesamtdicke jedes Arms (3, 3'), und
dadurch, dass die Breite jeder Nut (4a, 4a', 4b, 4b') zwischen 40 und 90 % der Breite jedes Arms (3, 3') beträgt.

2. Piezoelektrischer Resonator (1) nach Anspruch 1, wobei die Schwingarme (3, 3') mit der Basis (2) in einer Richtung einer X-Kristallachse verbunden sind, wobei sich die Schwingarme (3, 3') ausgehend von der Basis in einer Richtung einer +Y-Kristallachse erstrecken, wobei die erste Nut (4a, 4a') auf der oberen Fläche auf einer +Z-Seite jedes Arms (3, 3') gemäß der +Y-Kristallachse gebildet ist, wobei die zweite Nut (4b, 4b') auf der unteren Fläche auf einer -Z-Seite jedes Arms (3, 3') gemäß der +Y-Kristallachse gebildet ist, **dadurch gekennzeichnet, dass** die Tiefe der ersten Nut (4a, 4a') geringer ist als 30 % der Gesamtdicke jedes Arms (3, 3'), und dadurch, dass die Tiefe der zweiten Nut (4b, 4b') größer ist als 50 % der Gesamtdicke jedes Arms (3, 3').

3. Piezoelektrischer Resonator (1) nach Anspruch 2, **dadurch gekennzeichnet, dass** die erste Nut (4a, 4a') eine Tiefe von etwa 25 % der Gesamtdicke jedes Arms (3, 3') aufweist und dadurch, dass die zweite Nut (4b, 4b') eine Tiefe von etwa 65 % der Gesamtdicke jedes Arms (3, 3') aufweist.

4. Piezoelektrischer Resonator (1) nach Anspruch 1, wobei die Schwingarme (3, 3') mit der Basis (2) in einer Richtung einer X-Kristallachse verbunden sind, wobei sich die Schwingarme (3, 3') ausgehend von der Basis in einer Richtung einer -Y-Kristallachse erstrecken, wobei die erste Nut (4a, 4a') auf der oberen Fläche auf einer +Z-Seite jedes Arms (3, 3') gemäß der -Y-Kristallachse gebildet ist, wobei die zweite Nut (4b, 4b') auf der unteren Fläche auf einer -Z-Seite jedes Arms (3, 3') gemäß der -Y-Kristallachse gebildet ist, **dadurch gekennzeichnet, dass** die Tiefe der ersten Nut (4a, 4a') größer ist als 50 % der Gesamtdicke jedes Arms (3, 3') und dadurch, dass die Tiefe der zweiten Nut (4b, 4b') geringer ist als 30 % der Gesamtdicke jedes Arms (3, 3').

5. Piezoelektrischer Resonator (1) nach Anspruch 4, **dadurch gekennzeichnet, dass** die erste Nut (4a, 4a') eine Tiefe von etwa 65 % der Gesamtdicke jedes Arms (3, 3') aufweist und dadurch, dass die zweite Nut (4b, 4b') eine Tiefe von etwa 25 % der Gesamtdicke jedes Arms (3, 3') aufweist.

6. Piezoelektrischer Resonator (1) nach Anspruch 1, **dadurch gekennzeichnet, dass** die Breite jeder Nut (4a, 4a', 4b, 4b') etwa 42 µm beträgt und dadurch, dass die Breite jedes Arms (3, 3') etwa 52 µm beträgt.

7. Piezoelektrischer Resonator (1) nach Anspruch 1, **dadurch gekennzeichnet, dass** jede Nut (4a, 4a', 4b, 4b') auf der Länge jedes Arms (3, 3') zentriert ist.

8. Piezoelektrischer Resonator (1) nach einem der vorstehenden Ansprüche, **dadurch gekennzeichnet, dass** die Länge jeder Nut (4a, 4a', 4b, 4b') zwischen 5 und 100 % der Länge jedes Arms (3, 3') beträgt.

9. Piezoelektrischer Resonator (1) nach Anspruch 8, **dadurch gekennzeichnet, dass** die Länge jeder Nut (4a, 4a', 4b, 4b') etwa 700 µm beträgt und dadurch, dass die Länge jedes Arms (3, 3') ausgehend von der Basis (2) etwa 1160 µm beträgt.

10. Piezoelektrischer Resonator (1) nach Anspruch 9, **dadurch gekennzeichnet, dass** ein Abstand zwischen jedem Arm (3, 3') 330 µm beträgt.

11. Piezoelektrischer Resonator (1) nach Anspruch 1, **dadurch gekennzeichnet, dass** der Resonator ein Stimmgabel-Resonator mit Quarz mit zwei gleich langen Armen (3, 3') ausgehend von der Basis (2) ist und von dem mindestens zwei Abschnitte der Arme (3, 3') parallel zueinander angeordnet sind.

12. Piezoelektrischer Resonator (1) nach Anspruch 1, **dadurch gekennzeichnet, dass** die Basis (2) und die zwei Arme (3, 3') die gleiche Dicke aufweisen.

13. Piezoelektrischer Resonator (1) nach Anspruch 1, **dadurch gekennzeichnet, dass** jede Nut (4a, 4a', 4b, 4b') eine Tiefe und/oder eine Breite aufweist, die auf der Länge jedes Arms (3, 3') progressiv oder stufenweise variieren.

14. Piezoelektrischer Resonator (1) nach Anspruch 1, wobei der Resonator einen ersten länglichen Abschnitt jedes Arms (3, 3') umfasst, der mit der Basis (2) durch einen Verbindungsteil verbunden und parallel zu der Basis (2) ist, und einen zweiten länglichen Abschnitt jedes Arms (3, 3') parallel zu dem ersten Abschnitt, der mit dem ersten länglichen Abschnitt durch einen Querteil, der in der Richtung der X-Achse ausgerichtet ist, verbunden ist,
**dadurch gekennzeichnet, dass** der Resonator eine erste Nut (4a, 4a') mit einer ersten Tiefe und eine erste komplementäre Nut (14a, 14a') mit einer zweiten Tiefe, die sich von der ersten Tiefe unterscheidet, umfasst, die auf der oberen Fläche des ersten Abschnitts jedes Arms (3, 3') ausgeführt sind, dadurch, dass er eine dritte Nut (6a, 6a'), welche die zweite Tiefe aufweist, und eine dritte komplementäre Nut (16a, 16a'), welche die erste Tiefe aufweist, umfasst, die auf der oberen Fläche des zweiten Abschnitts jedes Arms (3, 3') ausgeführt sind, dadurch, dass er die zweite Nut (4b, 4b'), welche die zweite Tiefe aufweist, und eine zweite komplementäre Nut (14b, 14b'), welche die erste Tiefe aufweist, umfasst, die auf einer unteren Fläche des ersten Abschnitts jedes Arms (3, 3') jeweils gegenüber der ersten Nut (4a, 4a') und ersten komplementären Nut (14a, 14a') der oberen Fläche des ersten Abschnitts jedes Arms (3, 3') ausgeführt sind, dadurch, dass er eine vierte Nut (6b, 6b'), welche die erste Tiefe aufweist, und eine vierte komplementäre Nut (16b, 16b'), welche die zweite Tiefe aufweist, umfasst, die auf der unteren Fläche des zweiten Abschnitts jedes Arms (3, 3') jeweils gegenüber der dritten Nut (6a, 6a') und dritten komplementären Nut (16a, 16a') der oberen Fläche des zweiten Abschnitts jedes Arms (3, 3') ausgeführt sind, und dadurch, dass die erste Tiefe größer ist als 50 % der Gesamtdicke jedes Arms und die zweite Tiefe geringer ist als 30 % der Gesamtdicke jedes Arms, oder die erste Tiefe geringer ist als 30 % der Gesamtdicke jedes Arms und die zweite Tiefe größer ist als 50 % der Gesamtdicke jedes Arms, wobei jede Nut mit der entsprechenden komplementären Nut eine durchgängige oder segmentierte Nut bildet, die auf der gleichen Seite ihres gemeinsamen Arms aufgereiht ist.

15. Piezoelektrischer Resonator (1) nach Anspruch 1, wobei der Resonator einen ersten länglichen Abschnitt jedes Arms (3, 3') umfasst, der mit der Basis (2) durch einen Verbindungsteil verbunden und parallel zu der Basis (2) ist, und einen zweiten länglichen Abschnitt jedes Arms (3, 3') parallel zu dem ersten Abschnitt, der mit dem ersten länglichen Abschnitt durch einen Querteil, der in der Richtung der X-Achse ausgerichtet ist, verbunden ist,
**dadurch gekennzeichnet, dass** der Resonator die erste Nut (4a, 4a') mit einer ersten Tiefe und eine erste komplementäre Nut (14a, 14a') mit einer zweiten Tiefe, die sich von der ersten Tiefe unterscheidet, umfasst, die auf der oberen Fläche des ersten Abschnitts jedes Arms (3, 3') ausgeführt sind, dadurch, dass er eine dritte Nut (6a, 6a'), welche die erste Tiefe aufweist, und eine dritte komplementäre Nut (16a, 16a'), welche die zweite Tiefe aufweist, umfasst, die auf der oberen Fläche des zweiten Abschnitts jedes Arms (3, 3') ausgeführt sind, dadurch, dass er die zweite Nut (4b, 4b'), welche die zweite Tiefe aufweist, und eine zweite komplementäre Nut (14b, 14b'), welche die erste Tiefe aufweist, umfasst, die auf einer unteren Fläche des ersten Abschnitts jedes Arms (3, 3') jeweils gegenüber der ersten Nut (4a, 4a') und ersten komplementären Nut (14a, 14a') der oberen Fläche jedes ersten Armabschnitts ausgeführt sind, dadurch, dass er eine vierte Nut (6b, 6b'), welche die zweite Tiefe aufweist, und eine vierte komplementäre Nut (16b, 16b'), welche die erste Tiefe aufweist, umfasst, die auf der unteren Fläche des zweiten Abschnitts jedes Arms (3, 3') jeweils gegenüber der dritten Nut (6a, 6a') und dritten komplementären Nut (16a, 16a') der oberen Fläche des zweiten Abschnitts jedes Arms (3, 3') ausgeführt sind, und dadurch, dass die erste Tiefe größer ist als 50 % der Gesamtdicke jedes Arms und die zweite Tiefe geringer ist als 30 % der Gesamtdicke jedes Arms, oder die erste Tiefe geringer ist als 30 % der Gesamtdicke jedes Arms und die zweite Tiefe größer ist als 50 % der Gesamtdicke jedes Arms, wobei jede Nut mit der entsprechenden komplementären Nut eine durchgängige oder segmentierte Nut bildet, die auf der gleichen Seite ihres gemeinsamen Arms aufgereiht ist.

16. Piezoelektrischer Resonator (1) nach Anspruch 14 oder 15, **dadurch gekennzeichnet, dass** weitere erste, zweite, dritte und vierte komplementäre Nuten mit einer ersten oder zweiten Tiefe in Bezug auf die Gesamtdicke jedes Arms (3, 3') durchgängig oder in Segmenten jeder Nut vorgesehen sind, die auf den Abschnitten jedes Arms ausgeführt ist.

## Claims

1. Piezoelectric resonator (1) at quartz having X, Y and Z crystalline axis and comprising a base (2) and at least two vibrating arms (3, 3') connected to the base (2) in a direction of a crystalline axis X, wherein the vibrating arms (3, 3') extend from the base in a direction of a crystalline axis +Y or -Y, wherein at least a first groove (4a, 4a') is formed on an upper face on a side +Z of each arm (3, 3') along the crystalline axis +Y or -Y on part of the length of the arms (3, 3') and wherein at least a second groove (4b, 4b') is formed on a lower face on a side -Z of each arm (3, 3') along said crystalline axis +Y or -Y on part of the length of the arms (3, 3') and opposite the first groove (4a, 4a'), where the first groove and the second groove are formed with different depths,
**characterized in that** the depth of the first groove (4a, 4a') is less than 30% of the total thickness of each arm (3, 3') or more than 50% of the total thickness of each arm (3, 3'), and
**in that** the depth of the second groove (4b, 4b') is more than 50% of the total thickness of each arm (3, 3') if the depth of the first groove (4a, 4a') is less than 30% of the total thickness of each arm (3, 3'), or less than 30% of the total thickness of each arm (3, 3') if the depth of the first groove (4a, 4a') is more than 50% of the total thickness of each arm (3, 3'), and
**in that** the width of each groove (4a, 4a', 4b, 4b') is between 40% and 90% of the width of each arm (3, 3').

2. Piezoelectric resonator (1) according to claim 1, wherein the two vibrating arms (3, 3') are connected to the base (2) in a direction of a crystalline axis X, wherein the vibrating arms (3, 3') extend from the base in a direction of a crystalline axis +Y, wherein the first groove (4a, 4a') is formed on the upper face on a side +Z of each arm (3, 3') along the crystalline axis +Y wherein the second groove (4b, 4b') is formed on the lower face on a side -Z of each arm (3, 3') along the crystalline axis +Y,
**characterized in that** the depth of the first groove (4a, 4a') is less than 30% of the total thickness of each arm (3, 3'), and
**in that** the depth of the second groove (4b, 4b') is more than 50% of the total thickness of each arm (3, 3').

3. Piezoelectric resonator (1) according to claim 2, **characterized in that** the depth of the first groove (4a, 4a') is approximately 25% of the total thickness of each arm (3, 3'), and **in that** the depth of the second groove (4b, 4b') is approximately 65% of the total thickness of each arm (3, 3').

4. Piezoelectric resonator (1) according to claim 1, wherein the two vibrating arms (3, 3') are connected to the base (2) in a direction of a crystalline axis X, wherein the vibrating arms (3, 3') extend from the base in a direction of a crystalline axis -Y, wherein the first groove (4a, 4a') is formed on the upper face on a side +Z of each arm (3, 3') along the crystalline axis -Y wherein the second groove (4b, 4b') is formed on the lower face on a side -Z of each arm (3, 3') along the crystalline axis -Y,
**characterized in that** the depth of the first groove (4a, 4a') is more than 50% of the total thickness of each arm (3, 3'), and
**in that** the depth of the second groove (4b, 4b') is less than 30% of the total thickness of each arm (3, 3').

5. Piezoelectric resonator (1) according to claim 4, **characterized in that** the depth of the first groove (4a, 4a') is approximately 65% of the total thickness of each arm (3, 3'), and **in that** the depth of the second groove (4b, 4b') is approximately 25% of the total thickness of each arm (3, 3').

6. Piezoelectric resonator (1) according to claim 1, **characterized in that** the width of each groove (4a, 4a', 4b, 4b') is approximately 42 µm, and **in that** the width of each arm (3, 3') is approximately 52 µm.

7. Piezoelectric resonator (1) according to claim 1, **characterized in that** each groove (4a, 4a', 4b, 4b') is centred on the length of each arm (3, 3').

8. Piezoelectric resonator (1) according to any of the preceding claims, **characterized in that** the length of each groove (4a, 4a', 4b, 4b') is between 5% and 100% of the length of each arm (3, 3').

9. Piezoelectric resonator (1) according to claim 8, **characterized in that** the length of each groove (4a, 4a', 4b, 4b') is approximately 700 µm, and **in that** the length of each arm (3, 3') from the base (2) is approximately 1160 µm.

10. Piezoelectric resonator (1) according to claim 9, **characterized in that** a space between each arm (3, 3') is 330 µm.

11. Piezoelectric resonator (1) according to claim 1, **characterized in that** the resonator is a quartz tuning fork resonator with two arms (3, 3') of the same length from the base (2), and for which at least two portions of the arms (3, 3') are disposed parallel to each other.

12. Piezoelectric resonator (1) according to claim 1, **characterized in that** the base (2) and the two arms (3, 3') are the same thickness.

13. Piezoelectric resonator (1) according to claim 1, **characterized in that** the depth and/or the width of each groove (4a, 4a', 4b, 4b') varies over the length of each arm (3, 3') progressively or incrementally.

14. Piezoelectric resonator (1) according to claim 1, wherein the resonator comprises a first elongated portion of each arm (3, 3') connected to the base (2) by a connection part and parallel to the base (2) and a second elongated portion of each arm (3, 3') parallel to the first portion that is connected to the first elongated portion by a transverse part oriented in the direction of axis X, **characterized in that** the resonator comprises the first groove (4a, 4a') with a first depth and a first complementary groove (14a, 14a') with a second depth different from the first depth produced on the upper face of the first portion of each arm (3, 3'), **in that** it comprises a third groove (6a, 6a') having the second depth and a third complementary groove (16a, 16a') having the first depth produced on the upper face of the second portion of each arm (3, 3'), **in that** it comprises the second groove (4b, 4b') having the second depth and a second complementary groove (14b, 14b') having the first depth produced on the lower face of the first portion of each arm (3, 3') respectively opposite the first groove (4a, 4a') and first complementary groove (14a, 14a') of the upper face of the first portion of each arm (3, 3'), **in that** it comprises a fourth groove (6b, 6b') having the first depth and a fourth complementary groove (16b, 16b') having the second depth produced on the lower face of the second portion of each arm (3, 3') respectively opposite the third groove (6a, 6a') and third complementary groove (16a, 16a') of the upper face of the second portion of each arm (3, 3'), and **in that** the first depth is more than 50% of the total thickness of each arm, and the second depth is less than 30% of the total thickness of each arm, or the first depth is less than 30% of the total thickness of each arm, and the second depth is more than 50% of the total thickness of each arm, where each groove forms with the corresponding complementary groove a continuous or segmented groove of the same side of on the upper face of their common arm.

15. Piezoelectric resonator (1) according to claim 1, wherein the resonator comprises a first elongated portion of each arm (3, 3') connected to the base (2) by a connection part and parallel to the base (2) and a second elongated portion of each arm (3, 3') parallel to the first portion that is connected to the first elongated portion by a transverse part oriented in the direction of the axis X, **characterized in that** the resonator comprises the first groove (4a, 4a') with a first depth and a first complementary groove (14a, 14a') with a second depth different from the first depth produced on the upper face of the first portion of each arm (3, 3'), **in that** it comprises a third groove (6a, 6a') having the first depth and a third complementary groove (16a, 16a') having the second depth produced on the upper face of the second portion of each arm (3, 3'), **in that** it comprises the second groove (4b, 4b') having the second depth and a second complementary groove (14b, 14b') having the first depth produced on the lower face of the first portion of each arm (3, 3') respectively opposite the first groove (4a, 4a') and first complementary groove (14a, 14a') of the upper face of the first portion of each arm (3, 3'), **in that** it comprises a fourth groove (6b, 6b') having the second depth and a fourth complementary groove (16b, 16b') having the first depth different from the second depth produced on the lower face of the second portion of each arm (3, 3') respectively opposite the third groove (6a, 6a') and third complementary groove (16a, 16a') of the upper face of the second portion of each arm (3, 3'), and **in that** the first depth is more than 50% of the total thickness of each arm, and the second depth is less than 30% of the total thickness of each arm, or the first depth is less than 30% of the total thickness of each arm, and the second depth is more than 50% of the total thickness of each arm, where each groove forms with the corresponding complementary groove a continuous or segmented groove of the same side of on the upper face of their common arm.

16. Piezoelectric resonator (1) according to claim 13 or 14, **characterized in that** other first, second, third and fourth complementary grooves of a first or second depth relative to the thickness of each arm (3, 3') are provided in continuous or by segments of each groove produced on the portions of each arm.
